Europäisches Patentamt

European Patent Office

Office européen des brevets

(11) Publication number: 0 454 169 A2

# EUROPEAN PATENT APPLICATION

(21) Application number: 91106856.7

(22) Date of filing: 26.04.91

(51) Int. Cl.5: G03F 1/14, G03F 7/40

(30) Priority: 27.04.90 JP 113801/90

(43) Date of publication of application:
30.10.91 Bulletin 91/44

(84) Designated Contracting States:
DE FR

(71) Applicant: DAI NIPPON PRINTING CO., LTD.
1-1, Ichigaya-Kaga-Cho 1-chome Shinjuku-ku
Tokyo 162(JP)

(72) Inventor: Tabuchi, Kazuhiro, c/o Dai Nippon
Printing Co.,Ltd
1-1, Ichigaya-Kagacho 1-chome, Shinjuku-ku
Tokyo 162(JP)
Inventor: Inomata, Hiroyuki, c/o Dai Nippon
Printing Co.,Ltd
1-1, Ichigaya-Kagacho 1-chome, Shinjuku-ku
Tokyo 162(JP)
Inventor: Yamauchi, Takashi, c/o Dai Nippon
Printing Co.,Ltd
1-1, Ichigaya-Kagacho 1-chome, Shinjuku-ku
Tokyo 162(JP)

(74) Representative: Vossius & Partner
Siebertstrasse 4 P.O. Box 86 07 67
W-8000 München 80(DE)

(54) Photomask and method of treating the same.

(57) A photomask which is treated so that, even if the photomask is stained with a trace amount of contaminative particles during washing, water and a low-volatile component are prevented from adhering to such contaminative particles during the storage of the photomask, thereby preventing the photomask from becoming stained with passage of time. Also disclosed is a method of producing the photomask. The photomask is subjected to a hydrophobic treatment by a chemical reaction with OH groups in the mask surface. More specifically, the photomask has on the surface thereof a trimethylsilyl film which is formed from OH groups by the hydrophobic treatment. According to the treating method, the photomask which is to be subjected to a hydrophobic treatment is exposed to a gas atmosphere containing 1,1,1,3,3,3-hexamethyldisilazane, or it is coated with a treating solution containing 1,1,1,3,3,3-hexamethyldisilazane. Since the mask surface is subjected to a hydrophobic treatment by a chemical reaction with OH groups, even if contaminative particles attach to the photomask in a trace amount during washing, no water or low-volatile component will adhere to such contaminative particles during storage, so that the photomask is prevented from becoming stained with passage of time.

The present invention relates to a photomask used in a photolithographic process in the manufacture of semiconductor products, precision electronic parts, etc. and also relates to a method of treating the same.

Hitherto, photomasks employed in the manufacture of semiconductor products and the like have been produced by various methods and used to pattern semiconductor products, precision electronic parts, etc. In many cases, such photomasks are used repeatedly, and it is conventional practice to wash each photomask after use and store it in a casing as it is or with a pellicle attached thereto.

Since a photomask has heretofore been washed after use and stored in a casing as it is or with a pellicle attached thereto, as stated above, it is likely that the water content in the air and a low-volatile component contained in the material of the casing will adhere to contaminative particles attached to the photomask in a trace amount during or after the washing and the resulting stains will gradually grow with such particles at their centers, thus making an adverse effect on the pattern printing process. For this reason; it has been difficult to store the used photomasks for a long period of time.

In view of these circumstances, the present invention has been made by noting that the stain on a photomask is closely related to water on the mask, and it is an object of the present invention to provide a photomask which is treated so that, even if the photomask is stained with a trace amount of contaminative particles during washing, water and a low-volatile component are prevented from adhering to such contaminative particles during the storage of the photomask, thereby preventing the photomask from becoming stained with passage of time, and also provide a method of treating the photomask.

Noting the relation between the stain on a photomask and water thereon, the stain grows on the photomask during the storage in such a way that the water content in the air adheres to contaminative particles attached to the photomask in a trace amount during washing and the resulting stains gradually enlarge with the contaminative particles at their centers with passage of time, and further a low-volatile component contained in the casing, suspended dust, etc. adhere to the stains, causing the stained regions to enlarge. Accordingly, the growth of stains with passage of time can be effectively prevented by preventing the water content in the air and the low-volatile component from adhering to the photomask or contaminative particles, which have already been present thereon, during the storage.

The present invention provides a photomask, described below, which is free from the above-described problems, and a method of producing such a photomask.

The photomask of the present invention is characterized by having been subjected to a hydrophobic treatment by a chemical reaction with OH groups in the mask surface.

In general, the photomask is a reticle, a master mask or a working mask for the manufacture of a semiconductor product.

More specifically, the photomask has on the surface thereof a trimethylsilyl film which is formed from OH groups by the hydrophobic treatment, which is preferably a reaction of OH groups with 1,1,1,3,3,3-hexamethyldisilazane.

According to the treating method, the photomask which is to be subjected to a hydrophobic treatment is exposed to a gas atmosphere containing 1,1,1,3,3,3-hexamethyldisilazane, or it is coated with a treating solution containing 1,1,1,3,3,3-hexamethyldisilazane.

According to the present invention, since the mask surface has been subjected to a hydrophobic treatment by a chemical reaction with OH groups, even if contaminative particles are attached to the photomask in a trace amount during washing, no water or low-volatile component will adhere to such contaminative particles during storage, so that the photomask is prevented from becoming stained with passage of time.

In the present invention, it is particularly preferable to carry out the hydrophobic treatment with 1,1,1,3,3,3-hexamethyldisilazane.

Still other objects and advantages of the invention will in part be obvious and will in part be apparent from the specification.

The invention accordingly comprises the features of construction, combinations of elements, and arrangement of parts which will be exemplified in the construction hereinafter set forth, and the scope of the invention will be indicated in the claims.

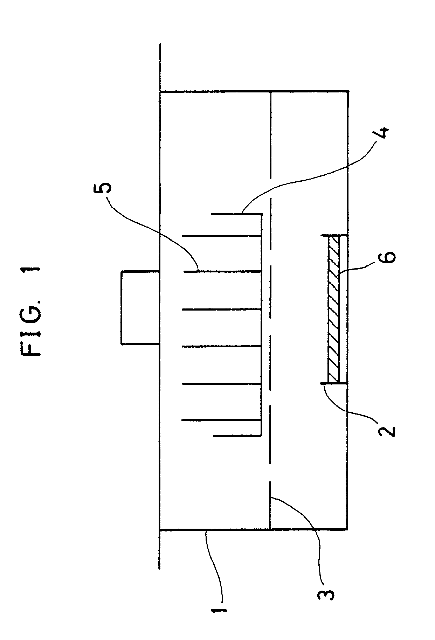

Fig. 1 shows the arrangement of an apparatus for subjecting a photomask to a hydrophobic treatment by a method according to a first embodiment of the present invention.

Embodiment 1 (gas diffusion method)

In this type of photomask, a pattern is drawn on a glass substrate with chromium (hereinafter referred to as "blank") coated with a photosensitive resin material (resist) by use, for example, of an EB lithography apparatus. Thereafter, developing, etching and other processes are carried out to make a reticle. Next, a blank is repeatedly exposed by use of a photorepeater and then subjected to necessary processes to make a master mask. Finally, the master mask is copied onto a blank by contact exposure with a printer and then subjected to necessary processes to make a working mask. As the photomask, a silver halide emulsion mask was commonly employed, but, with the increase in the integration density of ICs or the like, a chromium mask that is formed by depositing a chromium film on a glass substrate, a metal oxide mask, etc. have been increasingly used.

Such a photomask which is to be stored is washed and then dried. Next, the photomask is exposed for a predetermined time to a gas atmosphere, for example, 1,1,1,3,3,3-hexamethyldisilazane (hereinafter referred to as "HMDS"). For this purpose, a lidless container 2, for example, a laboratory dish, filled with HMDS 6 is placed in a hermetically sealed container 1 such as a desiccator, as shown in Fig. 1, and a carrier casing 4 in which reticles, master masks, working masks 5, etc., which are to be treated, are accommodated in spacings is placed in the upper part of the container 1. The carrier casing 4 accommodating the masks 5 is placed on a grating 3 or the like so that the HMDS gas will fill the container 1 uniformly.

Hydrophobicity of the mask surface is produced by a hydrophobic trimethylsilyl compound that is formed by reaction of HMDS with OH groups in the mask surface. The reaction of HMDS with OH groups takes place as follows:

$$2MOH + (CH_3)_3SiNHSi(CH_3)_3 \rightarrow 2MOSi(CH_3)_3 + NH_3$$

(wherein M is a metal, compound or the like combined with an OH group)

In the above, hydrophobicity is produced by $2MOSi(CH_3)_3$, which is a trimethylsilyl compound.

The time suitable for the hydrophobic treatment is in the range of from 2 or 3 minutes to several hours, particularly from 4 to 10 minutes.

Specifically, when a photomask was exposed for 4 minutes to HMDS vapor after being washed, no stain grew even after it was stored for one week. In contrast, a photomask which was not subjected to the above-described treatment had a large number of stains grown thereon.

In addition, the thickness of the reaction film formed by the hydrophobic treatment was several Å, so that there were no lowering in the transmittance, no effect on the resolving power and no deterioration of the mask.

Embodiment 2 (coating method)

The same photomask as in the embodiment 1 is coated with HMDS. Coating may be carried out by any known method. For example, spray, dip or spin coating method may be utilized. Excess HMDS can be speedily evaporated in a draft or under reduced pressure.

Although in the foregoing embodiments the present invention has been described assuming that photomasks are treated by batch process, a single photomask automatic transfer system may also be applied thereto.

As has been described above, the photomask of the present invention is subjected to a hydrophobic treatment by a chemical reaction with OH groups in the mask surface. Accordingly, even if contaminative particles are attached to the photomask in a trace amount during washing, no water or low-volatile component will adhere to such contaminative particles during storage, so that the photomask is prevented from becoming stained with passage of time. Accordingly, the photomask can be stably stored for a long period of time.

In the present invention, it is particularly preferable to carry out the hydrophobic treatment with 1,1,1,3,3,3-hexamethyldisilazane.

## Claims

1. A photomask characterized by having been subjected to a hydrophobic treatment by a chemical reaction with OH groups in the mask surface.

2. A photomask according to Claim 1, which is a reticle, a master mask or a working mask for the manufacture of a semiconductor product.

3. A photomask according to Claim 1 or 2, which has on the surface thereof a trimethylsilyl film which is formed from OH groups by said hydrophobic treatment.

4. A photomask according to Claim 3, wherein said hydrophobic treatment is a reaction of OH groups with 1,1,1,3,3,3-hexamethyldisilazane.

5. A method of producing the photomask defined in any of Claims 1 to 4, wherein the photomask which is to be subjected to a hydrophobic treatment is exposed to a gas atmosphere containing 1,1,1,3,3,3-hexamethyldisilazane.

6. A method of producing the photomask defined in any of Claims 1 to 4, wherein the photomask which is to be subjected to a hydrophobic treatment is coated with a treating solution containing 1,1,1,3,3,3-hexamethyldisilazane.

FIG. 1